# EUROPEAN PATENT APPLICATION

(11) **EP 4 797 927 A1**
(43) Date of publication of application: **26.08.2026**
(21) Application number: 25220311.2
(22) Date of filing: 03.12.2025
(51) Int. Cl.: H10P 54/00, H10W 42/00, H10P 54/20, H10P 54/40, H10P 58/00, H10W 46/00, H10W 74/10, H10W 74/43

(54) **SEMICONDUCTOR DEVICE**

(30) Priority: 25.02.2025 KR 20250024013
(71) Applicant: SK hynix Inc., Bubal-eub Icheon-si Gyeonggi-do 17336 (KR)
(72) Inventor: CHANG, Heon Yong, 17336 Icheon-si (KR)
(74) Representative: Isarpatent

(57) **Abstract**

A semiconductor device including a substrate; an insulating layer disposed on the substrate, and including an outer boundary; a passivation layer disposed on the insulating layer, and including an inner boundary that is located inward of the outer boundary; a dummy pattern layer having a lower surface that forms the same plane with the lower surface of the passivation layer, overlapping at least a part of a region disposed between the outer and inner boundaries, and having a side surface that is located inward of the inner boundary; and a redistribution pattern layer disposed on the dummy pattern layer.

## Description

### CROSS-REFERENCE TO RELATED APPLICATION

The present application claims priority under 35 U.S.C. §119(a) to Korean Patent Application No. 10-2025-0024013 filed on February 25, 2025, which is incorporated herein by reference in its entirety.

### BACKGROUND

### 1. Technical Field

Embodiments of the present disclosure relate generally to a semiconductor device, and more particularly to a semiconductor device including a redistribution layer (RDL) pattern.

### 2. Related Art

Semiconductor devices are attracting attention as an important element in the electronics industry due to their characteristics such as miniaturization, multi-functionality and/or low manufacturing cost. As the electronics industry advances, semiconductor devices are increasingly required to be highly integrated.

To meet the requirements for high integration, semiconductor devices may include redistribution layer (RDL) patterns. The redistribution layer patterns may be electrically connected to chip pads, and may extend from a region where the chip pads are disposed to another region.

### SUMMARY

The advantages of embodiments of the present disclosure are not limited to the advantages mentioned in this specification, and other advantages not mentioned will be clearly understood by those skilled in the art from the description below.

Embodiments of the present disclosure are directed to providing a semiconductor device capable of preventing deterioration of device characteristics due to process defects.

In an embodiment of the present disclosure, a semiconductor device may include a substrate; an insulating layer disposed on the substrate, and including an outer boundary; a passivation layer located on the insulating layer, and including an inner boundary that is located inward of the outer boundary; a dummy pattern layer having a lower surface that forms the same plane with the lower surface of the passivation layer, overlapping at least a part of a region between the outer and inner boundaries, and having one side surface that is located inward of the inner boundary; and a redistribution pattern layer disposed on the dummy pattern layer.

In an embodiment of the present disclosure, a semiconductor device may include a substrate including a chip region and a scribe lane region; an insulating layer disposed on the substrate; a dummy pattern layer disposed on the insulating layer in the scribe lane region; a passivation layer located on the insulating layer, and at least partially overlapping with the dummy pattern layer; and a redistribution pattern layer disposed outward of the passivation layer to overlap with the upper surface of the dummy pattern layer, wherein one side surface of the dummy pattern layer is located inward of the side surface of the passivation layer.

According to the embodiments of the present disclosure, it is possible to prevent the device characteristics of a semiconductor device from deteriorating due to process defects.

The advantageous effects of embodiments of the present disclosure are not limited to those mentioned above, and other advantages not mentioned will be clearly understood by those skilled in the art from the detailed description.

### BRIEF DESCRIPTION OF THE DRAWINGS

The embodiments of the present disclosure will be more fully understood from the detailed description to be made below and the accompanying drawings, which are provided for illustration only and are not intended to limit the embodiments.
FIG. 1 is a view illustrating a wafer in which semiconductor devices according to embodiments of the present disclosure are integrated.
FIG. 2 is an enlarged view of a region A of FIG. 1.
FIG. 3 is a view illustrating a cross-sectional structure of a part indicated by a line I-I' of FIG. 2.
FIG. 4 to FIG. 6 are views illustrating other cross-sectional structures of the part indicated by the line I-I' of FIG. 2.
FIG. 7 to FIG. 12 are views illustrating a method of forming a semiconductor device according to an embodiment disclosed in FIG. 3.
FIG. 13 to FIG. 16 are views illustrating a method of forming a semiconductor device according to an embodiment disclosed in FIG. 4.
FIG. 17 is a view illustrating a method of forming a semiconductor device according to an embodiment disclosed in FIG. 5.
FIG. 18 is a view illustrating a method of forming a semiconductor device according to an embodiment disclosed in FIG. 6.

### DETAILED DESCRIPTION

Embodiments of the present disclosure are described in detail using the accompanying drawings. Specific structural and functional descriptions of these embodiments serve as illustrations to convey the technical concepts presented in the present disclosure. The drawings illustrate possible embodiments, but the scope of the present disclosure is not limited to the embodiments or examples described in this specification, allowing for diverse variations.

The cross-hatching throughout the figures illustrates corresponding or similar areas between the figures rather than indicating the materials associated with the areas.

When one element is identified as "connected" or "coupled" to another element, the elements may be connected or coupled directly or through an intervening element between the elements. When two elements are identified as "directly connected" or "directly coupled," one element is directly connected or directly coupled to the other element without an intervening element between the two elements.

When one element is identified as "on," "over," "under," or "beneath" another element, the elements may directly contact each other or an intervening element may be disposed between the elements.

Terms such as "vertical," "horizontal," "top," "bottom," "above," "below," "under," "beneath," "over," "on," "side," "upper," "uppermost," "lower," "lowermost," "front," "rear," "left," "right," "column," "row," "level," and other terms implying relative spatial relationship or orientation are utilized only for the purpose of ease of description or reference to a drawing and are not otherwise limiting. Other spatial relationships or orientations not shown in the drawings or described in the specification are possible within the scope of the present disclosure.

Terms such as "first" and "second" are used to distinguish between various elements and do not imply size, order, priority, quantity, or importance of the elements. For example, a first element may be named as a second element in one example, and the second element may be named as a first element in another example.

In the description, when an element included in an embodiment is described in singular form, the element may be interpreted to include a plurality of elements performing the same or similar functions.

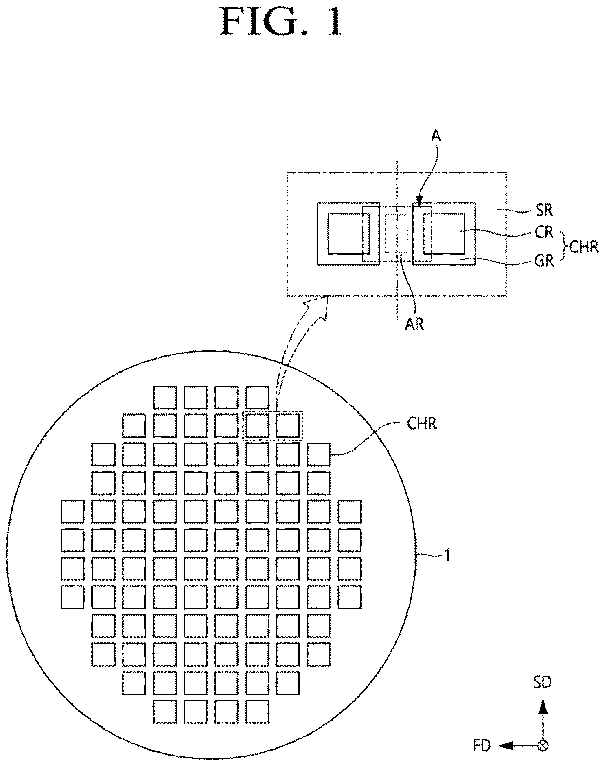

FIG. 1 is a view illustrating a wafer 1 in which semiconductor devices according to embodiments of the present disclosure are integrated.

Referring to FIG. 1, the wafer 1 may include a plurality of chip regions CHR and a scribe lane region SR.

The chip regions CHR may be regions where individual semiconductor chips are formed after the wafer 1 is diced. Integrated circuits for functioning as an individual semiconductor chip may exist in each chip region CHR. The chip region CHR may include a cell region CR and a guard ring region GR. The guard ring region GR may be continuous to the side surfaces of the cell region CR. The guard ring region GR may form a continuous frame surrounding the chip region CHR.

The scribe lane region SR may extend in a first direction FD and a second direction SD to surround the side surfaces of each chip region CHR. The first direction FD and the second direction SD may be substantially perpendicular to each other. The scribe lane region SR may be continuous to the chip region CHR. In a dicing process, the wafer 1 may be diced along a cutting line in the scribe lane region SR using a laser, a blade, etc.

The scribe lane region SR may include a redistribution alignment key region AR which is defined as the area where a redistribution alignment key is disposed. The redistribution alignment key may serve as a reference for alignment during an etching process of a redistribution pattern layer in the manufacturing of a semiconductor device.

The redistribution alignment key region AR may be located between neighboring chip regions CHR. Although FIG. 1 illustrates that the redistribution alignment key region AR is located between chip regions CHR neighboring each other in the first direction FD, a location where the redistribution alignment key region AR is disposed is not limited thereto.

Referring to FIG. 1, a first semiconductor device and a second semiconductor device neighboring thereto may be included in a partial region of the wafer 1. The region between the first semiconductor device and the second semiconductor device may be defined as region A.

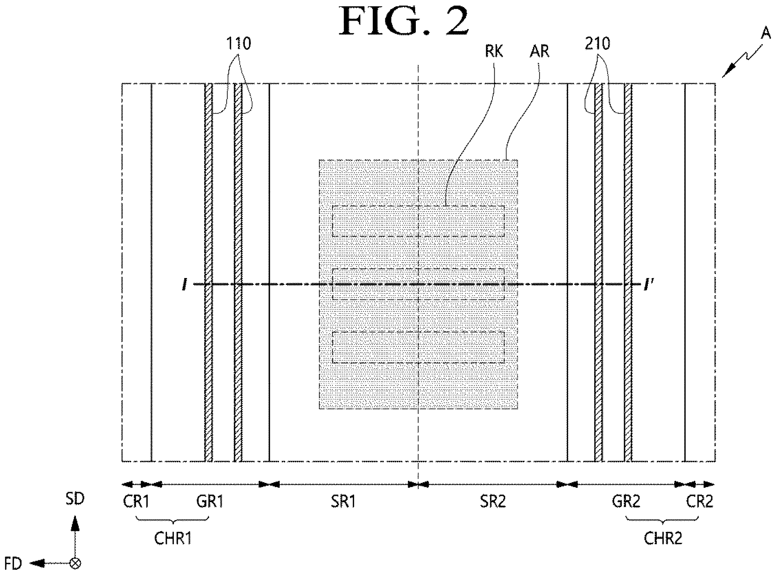

FIG. 2 is an enlarged view of the region A of FIG. 1.

A partial region of the first semiconductor device and a partial region of the second semiconductor device may be included in the region A.

Referring to FIG. 2, the first semiconductor device may include a first chip region CHR1 and a part of a first scribe lane region SR1 continuous thereto. The first chip region CHR1 may include a first cell region CR1 and a first guard ring region GR1. The first guard ring region GR1 may be continuous to the first cell region CR1. The first guard ring region GR1 may include a first guard ring 110. The first guard ring 110 may extend to surround the edges of the first cell region CR1.

Although two first guard rings 110 are illustrated in the first guard ring region GR1 in FIG. 2, the embodiments are not necessarily limited thereto, and the first guard ring region GR1 may have one or more first guard rings 110, preferably two or more first guard rings 110.

Referring to FIG. 2, the second semiconductor device may include a second chip region CHR2 and a part of a second scribe lane region SR2 continuous to the second chip region CHR2. The second chip region CHR2 may include a second cell region CR2 and a second guard ring region GR2. The second guard ring region GR2 may be continuous to the second cell region CR2. The second guard ring region GR2 may include a second guard ring 210. The second guard ring 210 may extend to surround the edges of the second cell region CR2.

Although two second guard rings 210 are illustrated in the second guard ring region GR2 in FIG. 2, the embodiments are not necessarily limited thereto, and the second guard ring region GR2 may have one or more second guard rings 210, preferably two or more second guard rings 210.

The redistribution alignment key region AR may be disposed in partial regions of the first scribe lane region SR1 and the second scribe lane region SR2. A redistribution alignment key RK may be disposed in the redistribution alignment key region AR. The redistribution alignment key RK may be used for alignment for etching a redistribution pattern layer in the manufacturing process of a semiconductor device.

Although, in FIG. 2, three redistribution alignment keys RK are illustrated in the redistribution alignment key region AR, the embodiments are not necessarily limited thereto, and the redistribution alignment key region AR may have one or more redistribution alignment keys RK.

In an embodiment, the redistribution alignment key RK may be disposed in a bar shape on a plane defined by the first direction FD and the second direction SD as illustrated in FIG. 2, but the embodiments are not limited thereto.

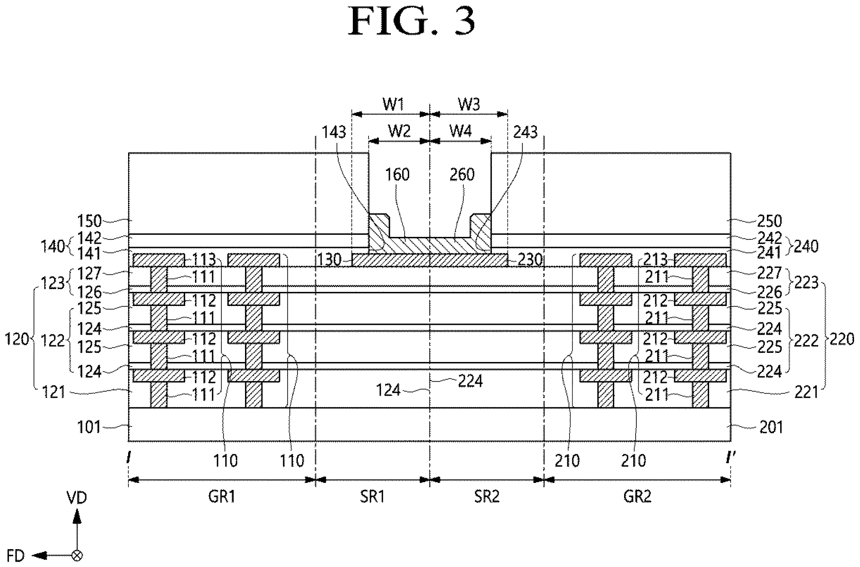

FIG. 3 is a view illustrating a cross-sectional structure of a part indicated by a line I-I' of FIG. 2.

Referring to FIG. 3, the first semiconductor device may include a first substrate 101, the first guard ring 110, a first insulating layer 120, a first dummy pattern layer 130, a first passivation layer 140, a first redistribution insulating layer 150, and a first redistribution pattern layer 160.

The first semiconductor device may include a first outer boundary 124. In an embodiment, the first outer boundary 124 may be a boundary that is located outermost among the boundaries of the first semiconductor device. In an embodiment, the outer boundary of the first insulating layer 120 may be the same as the first outer boundary 124. In an embodiment, the first outer boundary 124 may be located in the first scribe lane region SR1. The first passivation layer 140 may include a first inner boundary 143 in the first scribe lane region SR1. The first inner boundary 143 may be a boundary that is closer to the first guard ring region GR1 than the first outer boundary 124 among the boundaries of the first semiconductor device.

The first outer boundary 124 may extend in a third direction VD. The first inner boundary 143 may extend in the third direction VD. The first inner boundary 143 may be positioned at the interface between the first redistribution pattern layer 160 and the first passivation layer 140. The third direction VD may be substantially perpendicular to the first direction FD.

The first substrate 101 may be located in the first chip region CHR1 and the first scribe lane region SR1. The first chip region CHR1 may include the first cell region CR1 and the first guard ring region GR1.

The first guard ring 110 and the first insulating layer 120 may be disposed on the first substrate 101. The first substrate 101 may include a semiconductor substrate such as a silicon wafer or a silicon-on-insulator (SOI) wafer. The first substrate 101 may include a III-V group semiconductor substrate, for example, a compound semiconductor substrate such as gallium arsenide (GaAs). The first substrate 101 may include monocrystalline silicon, polysilicon, amorphous silicon, monocrystalline silicon germanium, polycrystalline silicon germanium, carbon-doped silicon or a combination thereof.

The first guard ring 110 may be disposed on the first substrate 101. The first guard ring 110 may be disposed in the first guard ring region GR1. The first guard ring 110 may be disposed inward of the first inner boundary 143. The first guard ring 110 may include a plurality of first guard metal contacts 111 extending in the third direction VD and a plurality of first guard metal layers 112 extending in the first direction FD.

In an embodiment, the first guard metal contacts 111 and the first guard metal layers 112 may include tungsten (W), tungsten nitride (WN), titanium (Ti), titanium nitride (TiN), aluminum (Al), copper (Cu), tantalum (Ta), tantalum nitride (TaN), gold (Au), or a combination of at least two thereof. Although FIG. 3 illustrates that the first guard ring 110 includes four first guard metal contacts 111 and four first guard metal layers 112, the embodiments are not necessarily limited thereto, and the first guard ring 110 may include various numbers of first guard metal contacts 111 and first guard metal layers 112.

Among the plurality of first guard metal layers 112, a first guard metal layer that is farthest away from the first substrate 101 in the third direction VD may be defined as a first upper guard metal layer 113.

The first upper guard metal layer 113 may be disposed on a first upper intermetal insulating layer 123. The upper surface of the first upper guard metal layer 113 may form the same plane with the upper surface of the first dummy pattern layer 130. The first upper guard metal layer 113 may include the same material as the first dummy pattern layer 130. In an embodiment, the first upper guard metal layer 113 may include aluminum (Al).

The first insulating layer 120 may be disposed on the first substrate 101. The first insulating layer 120 may include a first interlayer insulating layer 121, a first lower intermetal insulating layer 122, and the first upper intermetal insulating layer 123.

The first interlayer insulating layer 121 may include at least two selected from the group consisting of silicon (Si), oxygen (O), nitrogen (N), carbon (C), boron (B), phosphorus (P) and hydrogen (H). The first interlayer insulating layer 121 may include an insulating material having excellent step coverage and gapfill characteristics. In an embodiment, the first interlayer insulating layer 121 may include an oxide such as tetraethyl orthosilicate (TEOS) or borophosphosilicate glass (BPSG).

The first lower intermetal insulating layer 122 may be disposed on the first interlayer insulating layer 121. The first lower intermetal insulating layer 122 may include a first lower capping layer 124 and a first lower intermetal dielectric layer 125.

Although FIG. 3 illustrates two first lower intermetal insulating layers 122 stacked in the third direction VD, the embodiments are not necessarily limited thereto, and various numbers of first lower intermetal insulating layers 122 may be provided. For example, in an embodiment, there may be one or more first intermetal insulating layers 122.

The first lower intermetal dielectric layer 125 may be disposed on the first lower capping layer 124. In an embodiment, the first lower capping layer 124 may include nitride including silicon (Si), carbon (C) and nitrogen (N). In an embodiment, the first lower intermetal dielectric layer 125 may include low-k oxide.

The first upper intermetal insulating layer 123 may be disposed on the first lower intermetal insulating layer 122. The first upper intermetal insulating layer 123 may include a first upper capping layer 126 and a first upper intermetal dielectric layer 127.

In an embodiment, the first upper capping layer 126 may include substantially the same material as the first lower capping layer 124. In an embodiment, the first upper intermetal dielectric layer 127 may have a different constitution from the first lower intermetal dielectric layer 125. In an embodiment, the first upper intermetal dielectric layer 127 may include oxide with excellent step coverage and gapfill characteristics. In an embodiment, the first upper intermetal dielectric layer 127 may include oxide layer such as tetraethyl orthosilicate (TEOS).

The first dummy pattern layer 130 may be disposed on the first upper intermetal insulating layer 123. The lower surface of the first dummy pattern layer 130 may be coplanar (i.e., form the same plane) with the lower surface of the first passivation layer 140. The first dummy pattern layer 130 may overlap with at least a part of the region between the first outer boundary 124 and the first inner boundary 143. One side surface of the first dummy pattern layer 130 may be located inward of the first inner boundary 143.

The first dummy pattern layer 130 may have a first width W1. The first dummy pattern layer 130 may be located in the first scribe lane region SR1. The first dummy pattern layer 130 may be disposed on the first insulating layer 120. In an embodiment, the first dummy pattern layer 130 may include aluminum (Al).

The first passivation layer 140 may be disposed on the first insulating layer 120. The first passivation layer 140 may be located inward of the first outer boundary 124. The first passivation layer 140 may include the first inner boundary 143 that is located inward of the first outer boundary 124.

The first passivation layer 140 may include a first passivation oxide layer 141 adjacent to the first upper intermetal insulating layer 123 and a first passivation nitride layer 142 disposed on the first passivation oxide layer 141. In an embodiment, the first passivation layer 140 may include oxide, nitride, or a combination thereof. In an embodiment, the first passivation oxide layer 141 may include high density plasma (HDP) oxide.

The first redistribution insulating layer 150 may be disposed on the first passivation layer 140. In an embodiment, the first redistribution insulating layer 150 may include silicon oxide.

The first redistribution pattern layer 160 may be disposed on the first dummy pattern layer 130. The first redistribution pattern layer 160 may be located in the first scribe lane region SR1. The lower surface of the first redistribution pattern layer 160 may form the same plane with the upper surface of the first dummy pattern layer 130 and may have a second width W2. In an embodiment, the first width W1 of the first dummy pattern layer 130 may be wider than the second width W2 of the first redistribution pattern layer 160. In an embodiment, a lower (or bottom) surface of the first redistribution pattern layer 160 may be flat, and a top surface of the first redistribution pattern layer 160 may have a flat central portion and two leg end portions projecting upward giving the second redistribution pattern layer 160 an overall square bracket shape, with the flat part of the bracket extending parallel to the top surface of the first dummy pattern layer 130 and the legs extending vertically to the flat part.

The distance from the upper surface of the first redistribution insulating layer 150 to the first dummy pattern layer 130 may be larger than the distance from the uppermost surface of the first redistribution pattern layer 160 to the first dummy pattern layer 130. The first redistribution pattern layer 160 may contact the upper surface of the first dummy pattern layer 130 between the first outer boundary 124 and the first inner boundary 143. The first redistribution pattern layer 160 may contact the side surface of the first passivation layer 140 between the first outer boundary 124 and the first inner boundary 143. The bottom surface of the first redistribution pattern layer 160 may be lower than the top surface of the first oxidation passivation layer 141. In an embodiment, the top surface of the central portion of the top surface of the second redistribution pattern layer 160 may be coplanar with the top surface of the second passivation layer 140.

The first redistribution pattern layer 160 may be located outward of the side surface of the first passivation layer 140. The first redistribution pattern layer 160 may be disposed to overlap with the upper surface of the first dummy pattern layer 130.

Referring back to FIG. 3, the second semiconductor device may include a second substrate 201, the second guard ring 210, a second insulating layer 220, a second dummy pattern layer 230, a second passivation layer 240, a second redistribution insulating layer 250, and a second redistribution pattern layer 260.

The second semiconductor device may include a second outer boundary 224. In an embodiment, the second outer boundary 224 may be a boundary that is located outermost among the boundaries of the second semiconductor device. In an embodiment, the outer boundary of the second insulating layer 220 may be the same as the second outer boundary 224. In an embodiment, the second outer boundary 224 may be located in the second scribe lane region SR2. The second passivation layer 240 may include a second inner boundary 243 positioned inside the second scribe lane region SR2. The second inner boundary 243 may be closer to the second guard ring region GR2 than the second outer boundary 224.

The second outer boundary 224 may extend in the third direction VD. The second inner boundary 243 may extend in the third direction VD. The second inner boundary 243 may be positioned at the interface between the second redistribution pattern layer 260 and the second passivation layer 240.

The second substrate 201 may be located in the second chip region CHR2 and the second scribe lane region SR2. The second chip region CHR2 may include the second cell region CR2 and the second guard ring region GR2.

The second guard ring 210 and the second insulating layer 220 may be disposed on the second substrate 201. The second substrate 201 may include substantially the same material as the first substrate 101.

The second guard ring 210 may be disposed on the second substrate 201. The second guard ring 210 may be disposed in the second guard ring region GR2. The second guard ring 210 may be disposed inward of the second inner boundary 243. The second guard ring 210 may include a plurality of second guard metal contacts 211 extending in the third direction VD and a plurality of second guard metal layers 212 extending in the first direction FD.

In an embodiment, the second guard metal contact 211 or the second guard metal layer 212 may include substantially the same material as the first guard metal contact 111 or the first guard metal layer 112. Although FIG. 3 illustrates that the second guard ring 210 includes four second guard metal contacts 211 and four second guard metal layers 212, the embodiments are not necessarily limited thereto, and the second guard ring 210 may include various numbers of second guard metal contacts 211 and second guard metal layers 212.

Among the plurality of second guard metal layers 212, a second guard metal layer that is farthest away from the second substrate 201 in the third direction VD may be defined as a second upper guard metal layer 213.

The second upper guard metal layer 213 may be disposed on a second upper intermetal insulating layer 223. The upper surface of the second upper guard metal layer 213 may form the same plane with the upper surface of the second dummy pattern layer 230. The second upper guard metal layer 213 may include the same material as the second dummy pattern layer 230. In an embodiment, the second upper guard metal layer 213 may include substantially the same material as the first upper guard metal layer 113.

The second insulating layer 220 may be disposed on the second substrate 201. The second insulating layer 220 may include a second interlayer insulating layer 221, a second lower intermetal insulating layer 222, and the second upper intermetal insulating layer 223.

The second interlayer insulating layer 221 may include substantially the same material as the first interlayer insulating layer 121.

The second lower intermetal insulating layer 222 may be disposed on the second interlayer insulating layer 221. The second lower intermetal insulating layer 222 may include a second lower capping layer 224 and a second lower intermetal dielectric layer 225.

Although FIG. 3 illustrates two second lower intermetal insulating layers 222 stacked in the third direction VD, the embodiments are not necessarily limited thereto, and various numbers of second lower intermetal insulating layers 222 may be provided. For example, in an embodiment, there may be one or more second lower intermetal insulating layers 222.

The second lower intermetal dielectric layer 225 may be disposed on the second lower capping layer 224. In an embodiment, the second lower capping layer 224 may include substantially the same material as the first lower capping layer 124. In an embodiment, the second lower intermetal dielectric layer 225 may include substantially the same material as the first lower intermetal dielectric layer 125.

The second upper intermetal insulating layer 223 may be disposed on the second lower intermetal insulating layer 222. The second upper intermetal insulating layer 223 may include a second upper capping layer 226 and a second upper intermetal dielectric layer 227 disposed on the second upper capping layer 226.

In an embodiment, the second upper capping layer 226 may include substantially the same material as the first upper capping layer 126. In an embodiment, the second upper intermetal dielectric layer 227 may have a different constitution from the second lower intermetal dielectric layer 225. In an embodiment, the second upper intermetal dielectric layer 227 may include substantially the same material as the first upper intermetal dielectric layer 127.

The second dummy pattern layer 230 may be disposed on the second upper intermetal insulating layer 223. The lower surface of the second dummy pattern layer 230 may form the same plane with the lower surface of the second passivation layer 240. The second dummy pattern layer 230 may overlap at least a part of the region between the second outer boundary 224 and the second inner boundary 243. One side surface of the second dummy pattern layer 230 may be located inward of the second inner boundary 243.

The second dummy pattern layer 230 may have a third width W3. The second dummy pattern layer 230 may be located in the second scribe lane region SR2. The second dummy pattern layer 230 may be disposed on the second insulating layer 220. In an embodiment, the second dummy pattern layer 230 may include substantially the same material as the first dummy pattern layer 130.

The second passivation layer 240 may be disposed on the second insulating layer 220. The second passivation layer 240 may be located inward of the second outer boundary 224. The second passivation layer 240 may include the second inner boundary 243 that is located inward of the second outer boundary 224.

The second passivation layer 240 may include a second passivation oxide layer 241 and a second passivation nitride layer 242. In an embodiment, the second passivation layer 240 may include substantially the same material as the first passivation layer 140. In an embodiment, the second passivation oxide layer 241 may include substantially the same material as the first passivation oxide layer 141.

The second redistribution insulating layer 250 may be disposed on the second passivation layer 240. The second redistribution insulating layer 250 may include substantially the same material as the first redistribution insulating layer 150.

The second redistribution pattern layer 260 may be disposed on the second dummy pattern layer 230. The second redistribution pattern layer 260 may be located in the second scribe lane region SR2. The lower surface of the second redistribution pattern layer 260, which forms the same plane with the upper surface of the second dummy pattern layer 230, may have a fourth width W4. In an embodiment, the third width W3 may be wider than the fourth width W4.

The distance from the upper surface of the second redistribution insulating layer 250 to the second dummy pattern layer 230 may be larger than the distance from the uppermost surface of the second redistribution pattern layer 260 to the second dummy pattern layer 230. The second redistribution pattern layer 260 may contact the upper surface of the second dummy pattern layer 230 between the second outer boundary 224 and the second inner boundary 243. The second redistribution pattern layer 260 may contact the side surface of the second passivation layer 240 between the second outer boundary 224 and the second inner boundary 243. The bottom surface of the second redistribution pattern layer 260 may be lower than the top surface of the second oxidation passivation layer 241. In an embodiment, the top surface of the central portion of the top surface of the second redistribution pattern layer 260 may be coplanar with the top surface of the second passivation layer 240.

The second redistribution pattern layer 260 may be located outward of the side surface of the second passivation layer 240. The second redistribution pattern layer 260 may be disposed to overlap with the upper surface of the second dummy pattern layer 230. In an embodiment, a lower (or bottom) surface of the second redistribution pattern layer 260 may be flat, and a top surface of the second redistribution pattern layer 260 may have a flat central portion and two leg end portions projecting upward giving the second redistribution pattern layer 260 an overall square bracket shape, with the flat part of the bracket extending parallel to the top surface of the second dummy pattern layer 230 and the legs extending vertically to the flat part.

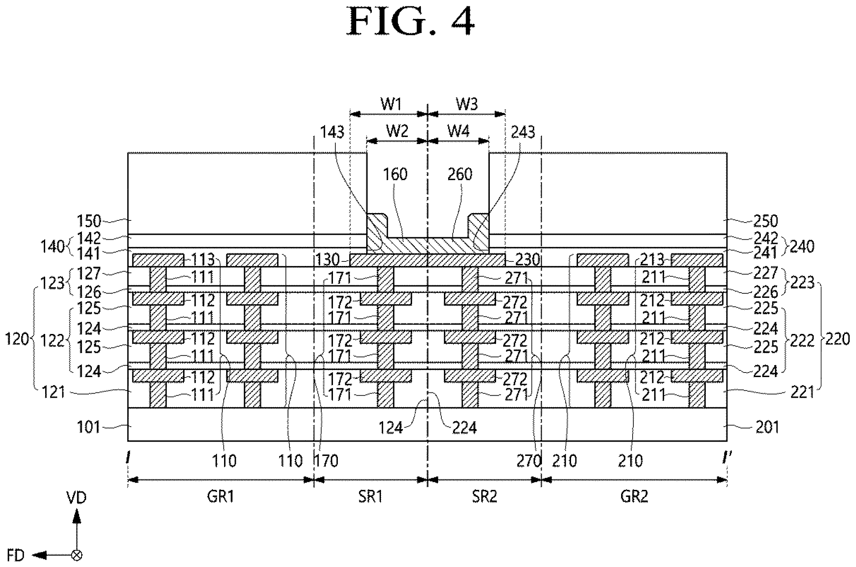

FIG. 4 is a view illustrating another cross-sectional structure of the part indicated by the line I-I' of FIG. 2.

In describing the following embodiments, description of components that are substantially the same as those in the previous embodiment will be omitted.

Referring to FIG. 4, the first semiconductor device may include a first substrate 101, the first guard ring 110, a first insulating layer 120, a first dummy pattern layer 130, a first passivation layer 140, a first redistribution insulating layer 150, a first redistribution pattern layer 160, and a first lower dummy pattern layer 170.

The first lower dummy pattern layer 170 may include a plurality of first dummy metal contacts 171 and a plurality of first dummy metal layers 172 that are connected by the plurality of first dummy metal contacts 171. The first dummy metal layers 172 may each extend horizontally (i.e., in parallel to the top surface of the substrate 101). The first dummy metal contacts 171 may each extend vertically to the top surface of the substrate 101. An uppermost first dummy metal contact 171 among the plurality of first dummy metal contacts 171 may be connected to the lower surface of the first dummy pattern layer 130.

In an embodiment, the first dummy metal contact 171 and the first dummy metal layer 172 may include tungsten (W), tungsten nitride (WN), titanium (Ti), titanium nitride (TiN), aluminum (Al), copper (Cu), tantalum (Ta), tantalum nitride (TaN), gold (Au), or a combination of at least two thereof.

Referring back to FIG. 4, the second semiconductor device may include a second substrate 201, the second guard ring 210, a second insulating layer 220, a second dummy pattern layer 230, a second passivation layer 240, a second redistribution insulating layer 250, a second redistribution pattern layer 260, and a second lower dummy pattern layer 270.

The second lower dummy pattern layer 270 may include a plurality of second dummy metal contacts 271 and a plurality of second dummy metal layers 272 that are connected by the plurality of second dummy metal contacts 271. The second dummy metal layers 272 may each extend horizontally (i.e., in parallel to the top surface of the substrate 201). The second dummy metal contacts 271 may each extend vertically to the top surface of the substrate 201. An uppermost second dummy metal contact 271 among the plurality of second dummy metal contacts 271 may be connected to the lower surface of the second dummy pattern layer 230.

In an embodiment, the second dummy metal contact 271 or the second dummy metal layer 272 may include substantially the same material as the first dummy metal contact 171 or the first dummy metal layer 172.

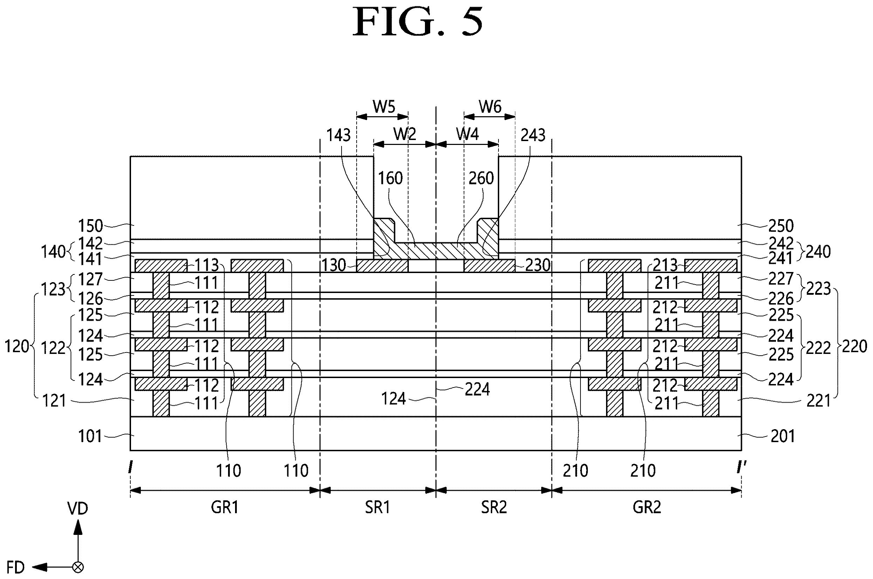

FIG. 5 is a view illustrating another cross-sectional structure of the part indicated by the line I-I' of FIG. 2.

Referring to FIG. 5, the first semiconductor device may include a first substrate 101, the first guard ring 110, a first insulating layer 120, a first dummy pattern layer 130, a first passivation layer 140, a first redistribution insulating layer 150, and a first redistribution pattern layer 160.

One side surface of the first dummy pattern layer 130 may be located inward of the first inner boundary 143. The one side surface of the first dummy pattern layer 130 may be located inward of the side surface of the first passivation layer 140. The other side surface of the first dummy pattern layer 130 may be located between the first outer boundary 124 and the first inner boundary 143. The other side surface of the first dummy pattern layer 130 may be located outward of the side surface of the first passivation layer 140.

The first dummy pattern layer 130 may have a fifth width W5. In an embodiment, the fifth width W5 may be wider than the second width W2. In the embodiment of FIG. 5, the side surface of the first dummy pattern layer 130 is positioned away from the first outer boundary 124, and may, for example, be positioned below a center portion of the first redistribution pattern layer 160. Thus, a portion of the bottom surface of the first redistribution pattern layer 160 may be in contact with the first passivation oxide layer 141.

Referring back to FIG. 5, the second semiconductor device may include a second substrate 201, the second guard ring 210, a second insulating layer 220, a second dummy pattern layer 230, a second passivation layer 240, a second redistribution insulating layer 250, and a second redistribution pattern layer 260.

One side surface of the second dummy pattern layer 230 may be located inward of the second inner boundary 243. The one side surface of the second dummy pattern layer 230 may be located inward of the side surface of the second passivation layer 240. The other side surface of the second dummy pattern layer 230 may be located between the second outer boundary 224 and the second inner boundary 243. The other side surface of the second dummy pattern layer 230 may be located outward of the side surface of the second passivation layer 240.

The second dummy pattern layer 230 may have a sixth width W6. In an embodiment, the sixth width W6 may be larger than the fourth width W4. In the embodiment of FIG. 5, the side surface of the second dummy pattern layer 230 is positioned away from the second outer boundary 224, and may, for example, be positioned below a center portion of the second redistribution pattern layer 260. Thus, a portion of the bottom surface of the second redistribution pattern layer 260 may be in contact with the second passivation oxide layer 241.

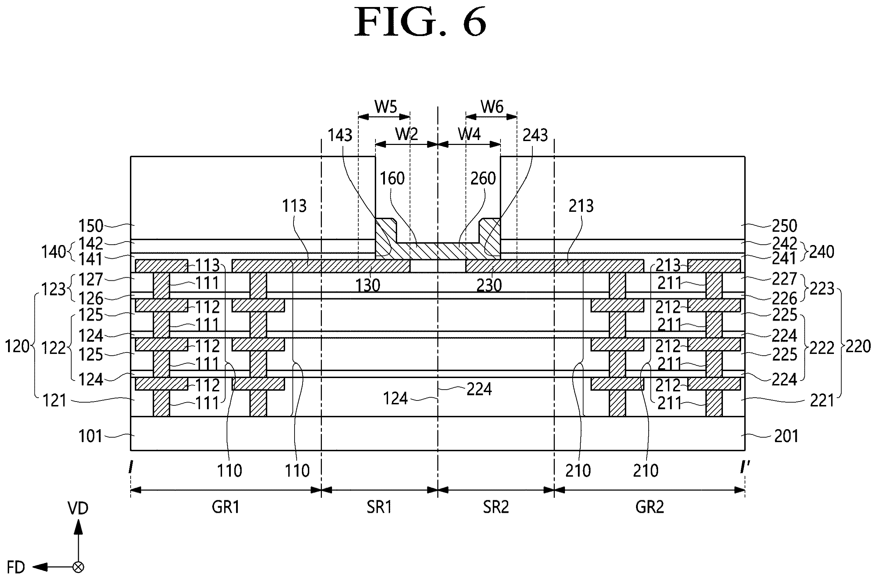

FIG. 6 is a view illustrating another cross-sectional structure of the part indicated by the line I-I' of FIG. 2.

Referring to FIG. 6, the first semiconductor device may include a first substrate 101, the first guard ring 110, a first insulating layer 120, a first dummy pattern layer 130, a first passivation layer 140, a first redistribution insulating layer 150, and a first redistribution pattern layer 160.

The first guard ring 110 may include the first upper guard metal layer 113 which is connected to one side surface of the first dummy pattern layer 130.

Referring back to FIG. 6, the second semiconductor device may include a second substrate 201, the second guard ring 210, a second insulating layer 220, a second dummy pattern layer 230, a second passivation layer 240, a second redistribution insulating layer 250, and a second redistribution pattern layer 260.

The second guard ring 210 may include the second upper guard metal layer 213 which is connected to one side surface of the second dummy pattern layer 230.

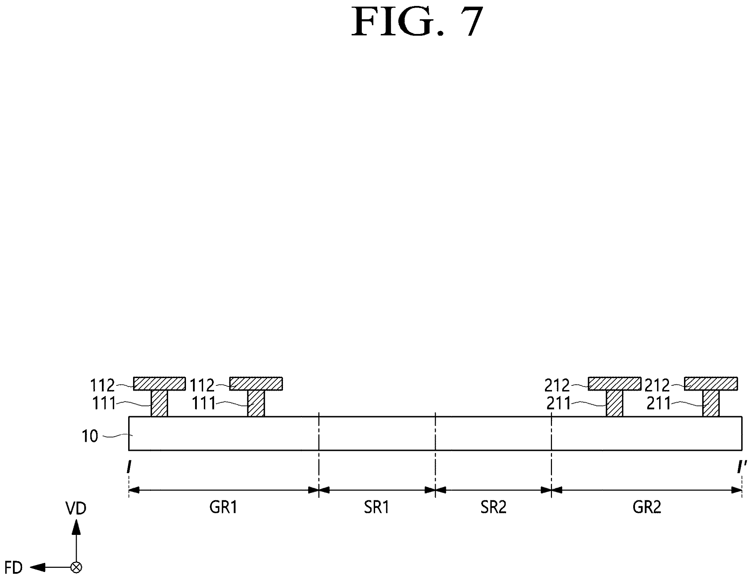

FIG. 7 to FIG. 12 are views illustrating a method of forming a semiconductor device according to an embodiment disclosed in FIG. 3.

Referring to FIG. 7, a first guard metal contact 111 and a second guard metal contact 211 may each be formed to extend vertically on a substrate 10. The first guard metal contact 111 may be located in a first guard ring region GR1. The second guard metal contact 211 may be located in a second guard ring region GR2. A first guard metal layer 112 may be formed on the first guard metal contact 111. A second guard metal layer 212 may be formed on the second guard metal contact 211. Each of the first and second guard metal layers 112, and 212 may extend in a horizontal direction parallel to the top surface of the substrate 10.

Referring back to FIG. 7, the first guard metal contact 111, the second guard metal contact 211, the first guard metal layer 112 and the second guard metal layer 212 might not be formed in the redistribution alignment key region AR.

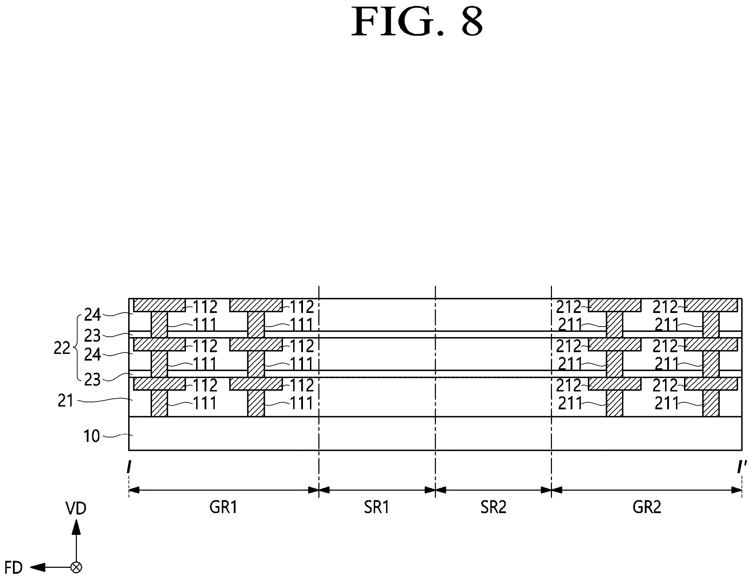

Referring to FIG. 8, an interlayer insulating layer 21 may be formed on the substrate 10 and, then a lower intermetal insulating layer 22 may be formed on the interlayer insulating layer 21. The lower intermetal insulating layer 22 may include a lower capping layer 23 and a lower intermetal dielectric layer 24.

The first guard metal contact 111 and the second guard metal contact 211 may be formed by penetrating the lower capping layer 23 and the lower intermetal dielectric layer 24. The first guard metal layer 112 may be formed on the first guard metal contact 111. The second guard metal layer 212 may be formed on the second guard metal contact 211.

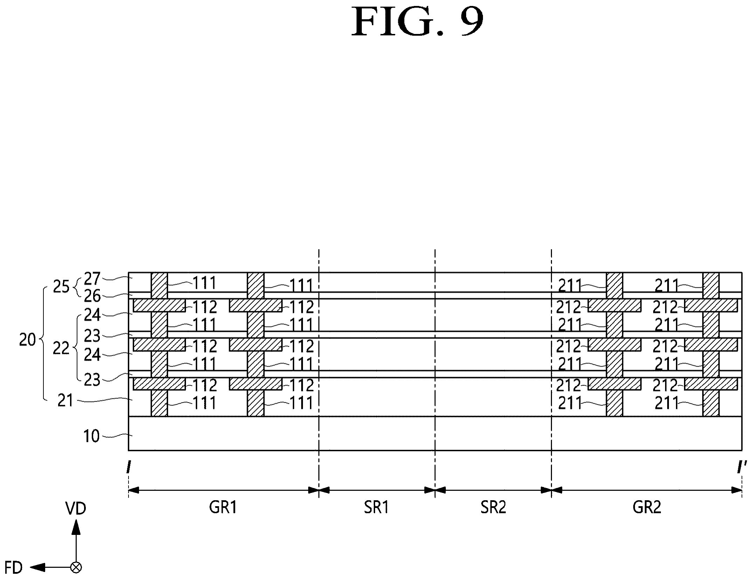

Referring to FIG. 9, an upper intermetal insulating layer 25 may be formed on the lower intermetal insulating layer 22. The upper intermetal insulating layer 25 may include an upper capping layer 26 and an upper intermetal dielectric layer 27 formed on the upper intermetal insulating layer 25. Thus, an insulating layer 20 may be formed on the substrate 10, the insulating layer 20 including the interlayer insulating layer 21, the lower intermetal insulating layer 22 and the upper intermetal insulating layer 25.

The first guard metal contact 111 and the second guard metal contact 211 may be formed by penetrating the upper capping layer 26 and the upper intermetal dielectric layer 27.

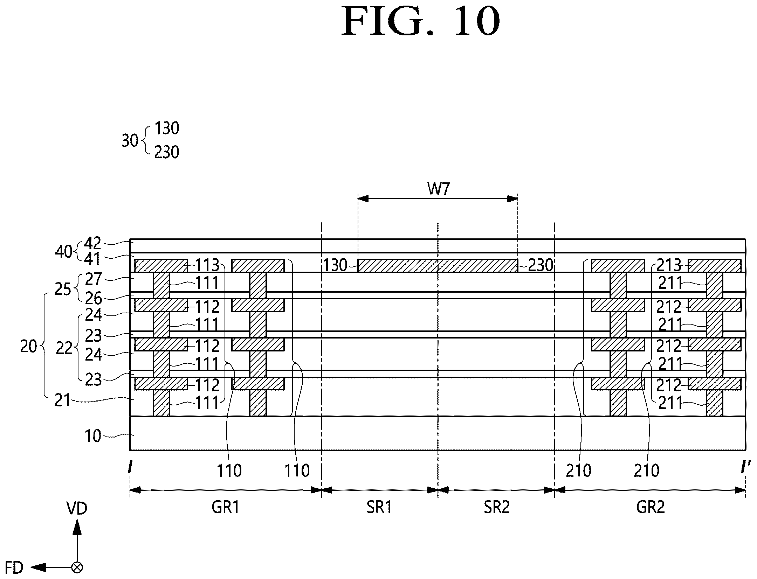

Referring to FIG. 10, a first upper guard metal layer 113 may be formed on the first guard metal contact 111. A second upper guard metal layer 213 may be formed on the second guard metal contact 211. A dummy pattern layer 30 may be formed on the insulating layer 20 in the scribe lane region SR. The dummy pattern layer 30 may include a first dummy pattern layer 130 and a second dummy pattern layer 230. The upper surface of the dummy pattern layer 30 may have a seventh width W7.

A passivation layer 40 may be formed on the insulating layer 20. The passivation layer 40 may include a passivation oxide layer 41 and a passivation nitride layer 42 formed on the passivation oxide layer 41.

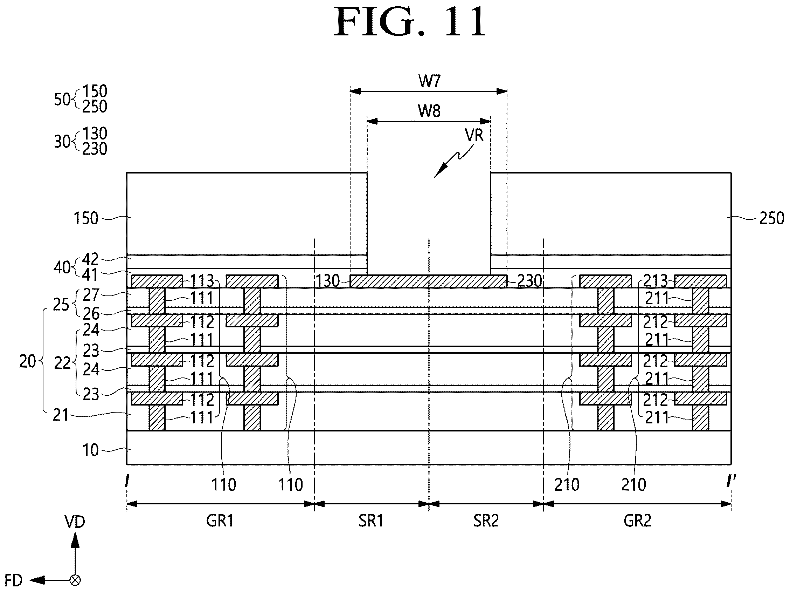

Referring to FIG. 11, a redistribution insulating layer 50 may be formed on the passivation layer 40. The redistribution insulating layer 50 may include a first redistribution insulating layer 150 and a second redistribution insulating layer 250.

A redistribution via region VR may be formed through the redistribution insulating layer 50 and a part of the passivation layer 40. The redistribution via region VR may be formed through anisotropic etching of the redistribution insulating layer 50 and the first passivation oxide layer 41 to expose a portion of the top surface of the first dummy pattern layer 130, and the second dummy pattern layer 230. In an embodiment, the redistribution via region VR may be a bar shape, but the embodiments are not limited thereto. The lower surface of the redistribution via region VR may contact a part of the upper surface of the dummy pattern layer 30. The lower surface of the redistribution via region VR may have an eighth width W8.

Because the seventh width W7 of the upper surface of the dummy pattern layer 30 is formed to be wider than the eighth width W8 of the lower surface of the redistribution via region VR, the dummy pattern layer 30 may serve as a buffer during an etching process. Accordingly, the insulating layer 20 located under the dummy pattern layer 30 might not be etched. Therefore, by preventing stress from being concentrated in the redistribution via region VR, a process defect such as a crack or a delamination may be controlled, thereby preventing deterioration of device characteristics.

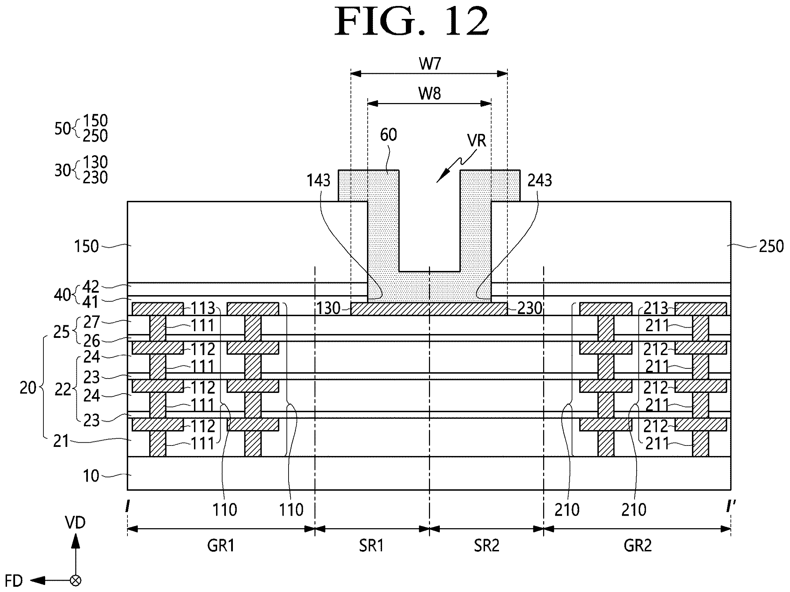

Referring to FIG. 12, a conductive material 60 may be formed on the upper surface of the dummy pattern layer 30, the side surface of the passivation layer 40, and the side surface and a part of the upper surface of the redistribution insulating layer 50. In an embodiment, the conductive material 60 may include aluminum (Al).

Because the conductive material 60 is bonded to the dummy pattern layer 30, stress concentration in the redistribution via region VR may be alleviated, thereby controlling a process defect such as a crack or a delamination at the bottom of the redistribution via region VR and thus preventing deterioration of device characteristics.

Referring back to FIG. 3, a part of the conductive material 60 may be removed through an etching process. Accordingly, a first redistribution pattern layer 160 and a second redistribution pattern layer 260 may be formed. The first redistribution pattern layer 160 may be located on the first dummy pattern layer 130. The second redistribution pattern layer 260 may be located on the second dummy pattern layer 230.

The distance from the upper surface of the first redistribution insulating layer 150 to the upper surface of the first dummy pattern layer 130 may be larger than the distance from the uppermost surface of the first redistribution pattern layer 160 to the upper surface of the first dummy pattern layer 130. The distance from the upper surface of the second redistribution insulating layer 250 to the upper surface of the second dummy pattern layer 230 may be larger than the distance from the uppermost surface of the second redistribution pattern layer 260 to the upper surface of the second dummy pattern layer 230.

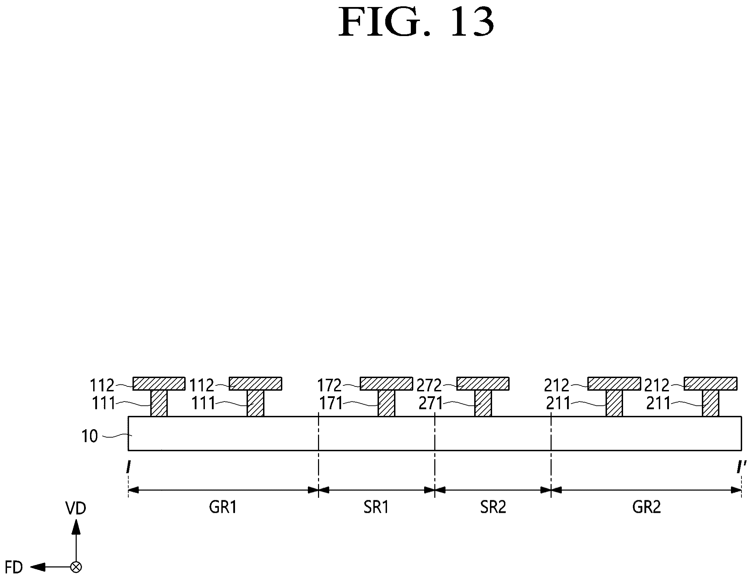

FIG. 13 to FIG. 16 are views illustrating a method of forming a semiconductor device according to an embodiment disclosed in FIG. 4.

Referring to FIG. 13, a first guard metal contact 111, a second guard metal contact 211, a first dummy metal contact 171 and a second dummy metal contact 271 may be formed on a substrate 10. The first guard metal contact 111 may be located in a first guard ring region GR1. The second guard metal contact 211 may be located in a second guard ring region GR2. The first dummy metal contact 171 may be located in a first scribe lane region SR1. The second dummy metal contact 271 may be located in a second scribe lane region SR2.

A first guard metal layer 112 may be formed on the first guard metal contact 111. A second guard metal layer 212 may be formed on the second guard metal contact 211. A first dummy metal layer 172 may be formed on the first dummy metal contact 171. A second dummy metal layer 272 may be formed on the second dummy metal contact 271.

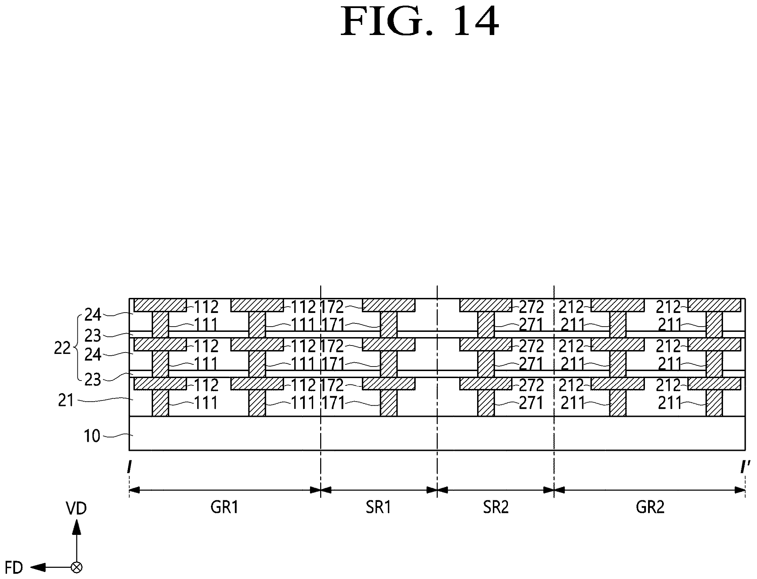

Referring to FIG. 14, an interlayer insulating layer 21 may be formed on the substrate 10. A lower intermetal insulating layer 22 may be formed on the interlayer insulating layer 21. The lower intermetal insulating layer 22 may include a lower capping layer 23 and a lower intermetal dielectric layer 24 formed on the lower capping layer 23.

The first guard metal contact 111, the second guard metal contact 211, the first dummy metal contact 171 and the second dummy metal contact 271 may be formed by penetrating the lower capping layer 23 and the lower intermetal dielectric layer 24. The first guard metal layer 112 may be formed on the first guard metal contact 111. The second guard metal layer 212 may be formed on the second guard metal contact 211. The first dummy metal layer 172 may be formed on the first dummy metal contact 171. The second dummy metal layer 272 may be formed on the second dummy metal contact 271.

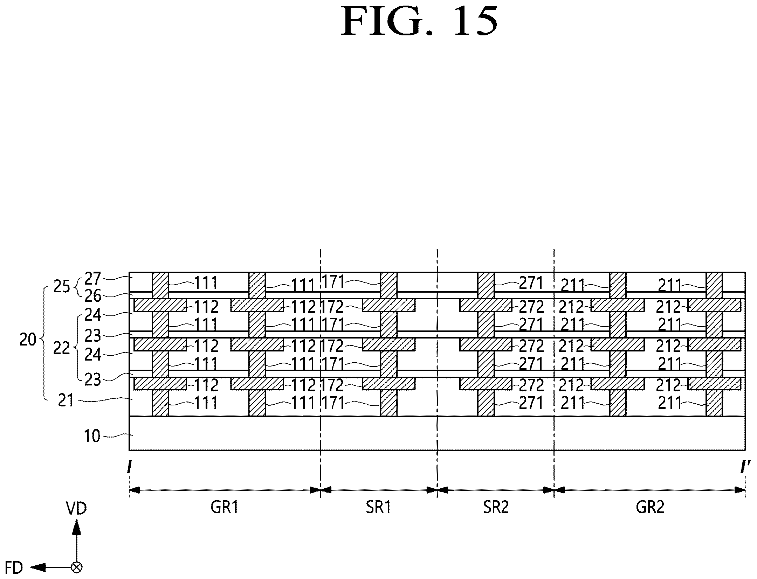

Referring to FIG. 15, an upper intermetal insulating layer 25 may be formed on the lower intermetal insulating layer 22. The upper intermetal insulating layer 25 may include an upper capping layer 26 and an upper intermetal dielectric layer 27 formed on the upper capping layer 26. This way insulating layer 20 may be formed on the substrate 10, the insulating layer 20 including the interlayer insulating layer 21, the lower intermetal insulating layer 22 and the upper intermetal insulating layer 25.

The first guard metal contact 111, the second guard metal contact 211, the first dummy metal contact 171 and the second dummy metal contact 271 may be formed by penetrating the upper capping layer 26 and the upper intermetal dielectric layer 27.

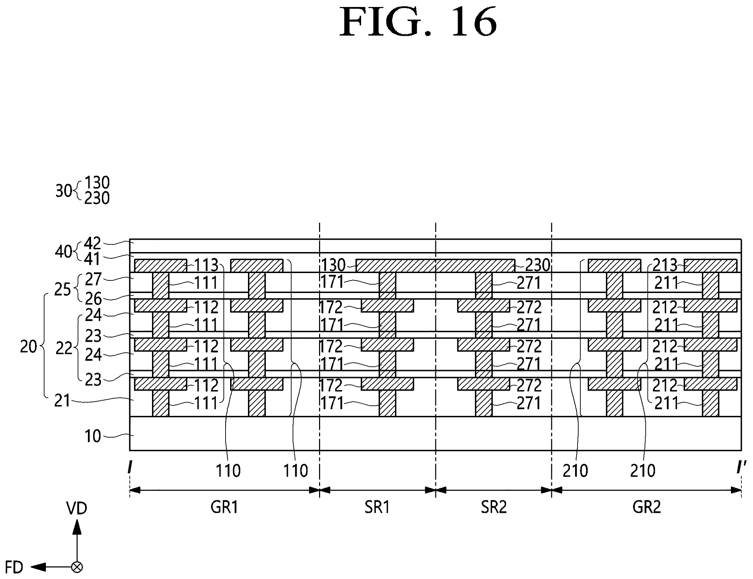

Referring to FIG. 16, a first upper guard metal layer 113 may be formed on the first guard metal contact 111. A second upper guard metal layer 213 may be formed on the second guard metal contact 211. A dummy pattern layer 30 may be formed on the insulating layer 20 in the scribe lane region SR. The dummy pattern layer 30 may include a first dummy pattern layer 130 and a second dummy pattern layer 230. The first dummy pattern layer 130 may be formed on the first dummy metal contact 171. The second dummy pattern layer 230 may be formed on the second dummy metal contact 271.

Referring back to FIG. 4 and FIG. 11, a redistribution insulating layer 50 may be formed on passivation layer 40. The redistribution insulating layer 50 may include a first redistribution insulating layer 150 and a second redistribution insulating layer 250.

A redistribution via region VR may be formed through the redistribution insulating layer 50 and a part of the passivation layer 40. The lower surface of the redistribution via region VR may contact a part of the upper surface of the dummy pattern layer 30. The lower surface of the redistribution via region VR may have an eighth width W8.

Referring to FIG. 4 and FIG. 12, a conductive material 60 may be formed on the upper surface of the dummy pattern layer 30, the side surface of the passivation layer 40, and the side surface and a part of the upper surface of the redistribution insulating layer 50.

Referring back to FIG. 4, a part of the conductive material 60 may be removed through an etching process. Accordingly, a first redistribution pattern layer 160 and a second redistribution pattern layer 260 may be formed. The first redistribution pattern layer 160 may be located on the first dummy pattern layer 130. The second redistribution pattern layer 260 may be located on the second dummy pattern layer 230.

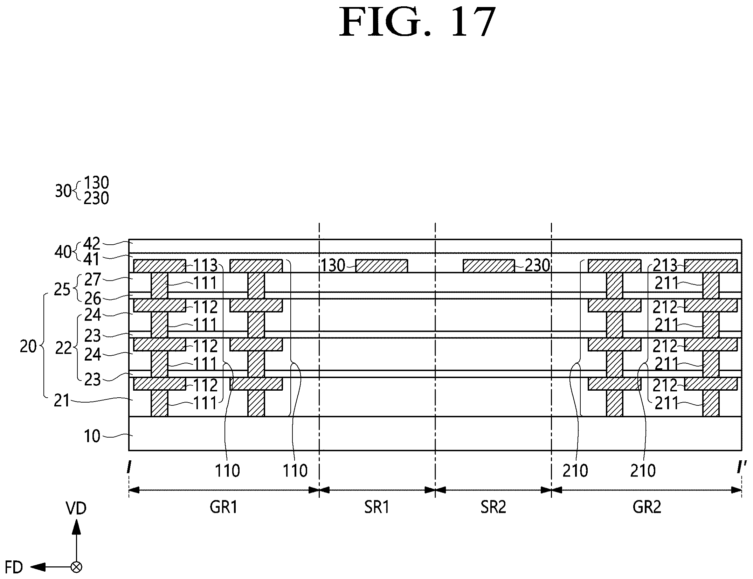

FIG. 17 is a view illustrating a method of forming a semiconductor device according to an embodiment disclosed in FIG. 5.

The semiconductor device illustrated in FIG. 17 may be formed by the same method as the method of manufacturing a semiconductor device described above with reference to FIG. 7 to FIG. 9.

Referring to FIG. 17, a first upper guard metal layer 113 may be formed on the first guard metal contact 111. A second upper guard metal layer 213 may be formed on the second guard metal contact 211. A first dummy pattern layer 130 and a second dummy pattern layer 230 may be formed on the insulating layer 20 in the scribe lane region SR.

Referring back to FIG. 5 and FIG. 11, a redistribution insulating layer 50 may be formed on a passivation layer 40. The redistribution insulating layer 50 may include a first redistribution insulating layer 150 and a second redistribution insulating layer 250.

A redistribution via region VR may be formed through the redistribution insulating layer 50 and a part of the passivation layer 40. The lower surface of the redistribution via region VR may contact a part of the upper surface of the dummy pattern layer 30. The lower surface of the redistribution via region VR may have an eighth width W8.

Referring to FIG. 5 and FIG. 12, a conductive material 60 may be formed on the upper surface of the dummy pattern layer 30, the side surface of the passivation layer 40, and the side surface and a part of the upper surface of the redistribution insulating layer 50.

Referring back to FIG. 5, a part of the conductive material 60 may be removed through an etching process. Accordingly, a first redistribution pattern layer 160 and a second redistribution pattern layer 260 may be formed. The first redistribution pattern layer 160 may be located on a part of the upper surface of the first dummy pattern layer 130. The second redistribution pattern layer 260 may be located on a part of the upper surface of the second dummy pattern layer 230.

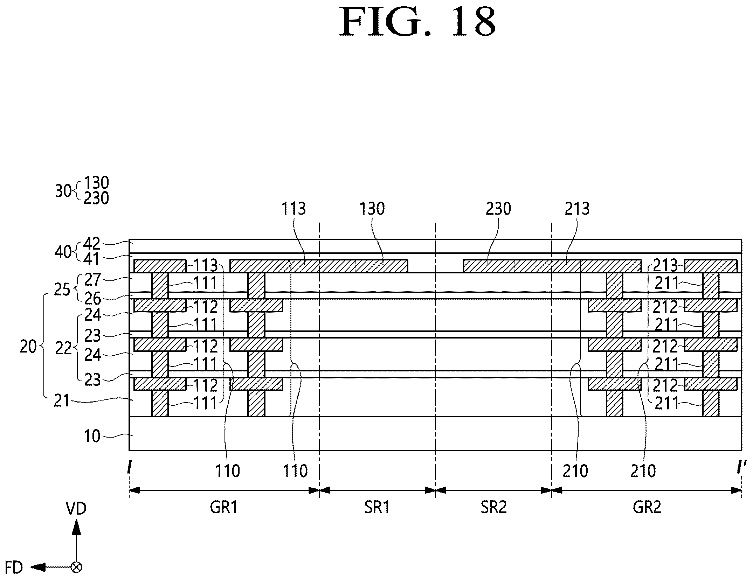

FIG. 18 is a view illustrating a method of forming a semiconductor device according to an embodiment disclosed in FIG. 6.

The semiconductor device illustrated in FIG. 18 may be formed by the same method as the method of manufacturing a semiconductor device described above with reference to FIG. 7 to FIG. 9.

Referring to FIG. 18, a first dummy pattern layer 130 and a second dummy pattern layer 230 may be formed on the insulating layer 20 in the scribe lane region SR.

A first upper guard metal layer 113 may be formed on an uppermost first guard metal contact 111 among the plurality of first guard metal contacts 111. In an illustrated embodiment of FIG. 18, the first upper guard metal layer 113 may be connected to one side surface of the first dummy pattern layer 130.

A second upper guard metal layer 213 may be formed on an uppermost second guard metal contact 211 among the plurality of second guard metal contacts 211. In the illustrated embodiment of FIG. 18, the second upper guard metal layer 213 may be connected to one side surface of the second dummy pattern layer 230.

Referring back to FIG. 6 and FIG. 11, a redistribution insulating layer 50 may be formed on a passivation layer 40. The redistribution insulating layer 50 may include a first redistribution insulating layer 150 and a second redistribution insulating layer 250.

A redistribution via region VR may be formed through the redistribution insulating layer 50 and a part of the passivation layer 40. The lower surface of the redistribution via region VR may contact a part of the upper surface of the dummy pattern layer 30. The lower surface of the redistribution via region VR may have an eighth width W8.

Referring to FIG. 6 and FIG. 12, a conductive material 60 may be formed on the upper surface of the dummy pattern layer 30, the side surface of the passivation layer 40, and the side surface and a part of the upper surface of the redistribution insulating layer 50.

Referring back to FIG. 6, a part of the conductive material 60 may be removed through an etching process. Accordingly, a first redistribution pattern layer 160 and a second redistribution pattern layer 260 may be formed. The first redistribution pattern layer 160 may be located on a part of the upper surface of the first dummy pattern layer 130. The second redistribution pattern layer 260 may be located on a part of the upper surface of the second dummy pattern layer 230.

While some detailed embodiments of the present disclosure are disclosed, those skilled in the art will understand that various modifications, additions, and substitutions related to these embodiments are possible without departing from the scope and technical concepts of the present disclosure. Therefore, the scope of the present disclosure should not be limited to the foregoing embodiments. All changes within the meaning and range of equivalency of the claims are included within their scope. Furthermore, the embodiments may be combined to form additional embodiments.

## Claims

1. A semiconductor device comprising:
an insulating layer disposed on a substrate, the insulating layer including an outer boundary;
a passivation layer disposed on the insulating layer, the passivation layer including an inner boundary;
a dummy pattern layer having a lower surface that is coplanar with a lower surface of the passivation layer; and
a redistribution pattern layer disposed on the dummy pattern layer,
wherein the dummy pattern layer is overlapping with at least a part of a region extending between the outer and inner boundaries, and
wherein one side surface of the dummy pattern layer is located inward of the inner boundary.

2. The semiconductor device according to claim 1, wherein the redistribution pattern layer contacts an upper surface of the dummy pattern layer and a side surface of the passivation layer disposed between the outer and inner boundaries.

3. The semiconductor device according to claim 2, further comprising
a redistribution insulating layer disposed on the passivation layer,
wherein a distance from an upper surface of the redistribution insulating layer to an upper surface of the dummy pattern layer is larger than a distance from an uppermost surface of the redistribution pattern layer to the upper surface of the dummy pattern layer.

4. The semiconductor device according to claim 1, wherein the passivation layer includes a high density plasma (HDP) oxide, a nitride, or a combination thereof.

5. The semiconductor device according to claim 1, further comprising a dummy metal contact connected to the lower surface of the dummy pattern layer.

6. The semiconductor device according to claim 1, wherein an other side surface of the dummy pattern layer is located between the outer and inner boundaries.

7. The semiconductor device according to claim 1, further comprising a guard ring disposed on the substrate and inward of the inner boundary.

8. The semiconductor device according to claim 7, wherein
the guard ring includes an upper guard metal layer, and
an upper surface of the upper guard metal layer is coplanar with a upper surface of the dummy pattern layer.

9. The semiconductor device according to claim 8, wherein the upper guard metal layer includes a same material as the dummy pattern layer.

10. The semiconductor device according to claim 8, wherein the upper guard metal layer is connected to the dummy pattern layer.

11. A semiconductor device comprising:
a substrate including a chip region and a scribe lane region;
an insulating layer disposed on the substrate;
a dummy pattern layer disposed on the insulating layer in the scribe lane region;
a passivation layer disposed on the insulating layer; and
a redistribution pattern layer disposed outward of the passivation layer to overlap with the dummy pattern layer,
wherein the passivation layer is at least partially overlapping with the dummy pattern layer, and
wherein one side surface of the dummy pattern layer is located inward of a side surface of the passivation layer.

12. The semiconductor device according to claim 11, wherein the redistribution pattern layer contacts the side surface of the passivation layer.

13. The semiconductor device according to claim 11, further comprising a redistribution insulating layer disposed on the passivation layer,
wherein a distance from an upper surface of the redistribution insulating layer to an upper surface of the dummy pattern layer is larger than a distance from an uppermost surface of the redistribution pattern layer to an upper surface of the dummy pattern layer.

14. The semiconductor device according to claim 11, wherein the passivation layer includes a high density plasma (HDP) oxide, a nitride, or a combination thereof.

15. The semiconductor device according to claim 11, further comprising a dummy metal contact connected to a lower surface of the dummy pattern layer.

16. The semiconductor device according to claim 11, wherein an other side surface of the dummy pattern layer is located outward of the side surface of the passivation layer.

17. The semiconductor device according to claim 11, further comprising a guard ring disposed on the substrate, and disposed inward of the side surface of the passivation layer.

18. The semiconductor device according to claim 17, wherein
the guard ring includes an upper guard metal layer, and
an upper surface of the upper guard metal layer is coplanar with a upper surface of the dummy pattern layer.

19. The semiconductor device according to claim 18, wherein the upper guard metal layer includes a same material as the dummy pattern layer.

20. The semiconductor device according to claim 18, wherein the upper guard metal layer is connected to the dummy pattern layer.
